# EUROPEAN PATENT APPLICATION

(11) **EP 4 717 735 A1**
(43) Date of publication of application: **01.04.2026**
(21) Application number: 24810861.5
(22) Date of filing: 02.05.2024
(51) Int. Cl.: C08L 101/00, B32B 15/08, B32B 27/00, C08J 5/24, C08K 3/013, C08K 9/06, C08L 9/00, C08L 79/08, H05K 1/03

(54) **RESIN COMPOSITION, PREPREG, LAMINATE, RESIN FILM, PRINTED WIRING BOARD, AND SEMICONDUCTOR PACKAGE**

(30) Priority: 22.05.2023 JP 2023083932
(71) Applicant: Resonac Corporation, Tokyo 105-7325 (JP)
(72) Inventor: TAKEGUCHI, Ayaka, Tokyo 105-7325 (JP); KAKITANI, Minoru, Tokyo 105-7325 (JP); SHIMIZU, Hiroshi, Tokyo 105-7325 (JP); TANIGAWA, Takao, Tokyo 105-7325 (JP); FUKUI, Masato, Tokyo 105-7325 (JP); AKEBI, Ryuji, Tokyo 105-7325 (JP); MURATA, Yuta, Tokyo 105-7325 (JP); OTSUKA, Kohei, Tokyo 105-7325 (JP); SATOU, Naoyosi, Tokyo 105-7325 (JP); HATAKEYAMA, Nene, Tokyo 105-7325 (JP)
(74) Representative: Hoffmann Eitle
(86) International application number: PCT/JP2024/016848
(87) International publication number: WO 2024/241853

(57) **Abstract**

The present invention relates to: a resin composition containing (A) a thermosetting resin, (B) one or more selected from the group consisting of a conjugated diene polymer and its derivative, having 2 or more of a functional group including an ethylenically unsaturated bond, and (C) an inorganic filler whose surface is treated with a silane coupling agent having a functional group including an ethylenically unsaturated bond; and a prepreg, a laminate, a resin film, a printed wiring board, and a semiconductor package, all of which use the said resin composition.

## Description

### [Technical Field]

The present embodiment relates to a resin composition, a prepreg, a laminate, a resin film, a printed wiring board, and a semiconductor package.

### [Background Art]

In electronic devices including a mobile communication device represented by a mobile phone, its base station equipment, internet infrastructure equipment such as a server and a router, and a large computer, year by year a processing speed as well as a storage capacity of a using signal is progressing. With this trend, the substrate of a printed wiring board that is mounted on these electronic devices is required to have dielectric characteristics that can lower a transmission loss, i.e., the characteristics of a low relative dielectric permittivity and a low dielectric dissipation factor.

For the printed wiring board, a heat resistance, mechanical characteristics, and the like that can withstand an use environment are required, so that thermosetting resins that are superior in these performances have been used. However, because many of the thermoplastic resin have a polar group, it has been difficult to improve the dielectric characteristics. Therefore, in the printed wiring board that requires a super-low transmission loss, a low-polar polymer that has superior dielectric characteristics is used together with a thermosetting resin.

With an aim to provide, among other things, a resin composition that is superior in a low relative dielectric permittivity, a low dielectric dissipation factor, a processability, and an adhesivity, Patent Document 1 discloses a resin composition that includes a polyimide resin (A), a phenylene ether resin (B), and a polybutadiene resin (C), in which the phenylene ether resin (B) contains in its molecular terminal at least one crosslinkable functional group selected from the group consisting of a phenolic hydroxy group, an acryl group, a vinyl group, and an epoxy group, and a number-average molecular weight of the polybutadiene resin (C) is in the range of 500 or more and 5000 or less.

### [Citation List]

### [Patent Document]

Patent Document 1: Japanese Patent Laid-Open Publication No. 2022-063409

### [Summary of the Invention]

### [Problems to be Solved by the Invention]

On the basis of the study by the inventors of the present invention, it has been clarified that blending of a polymer having excellent dielectric characteristics such as polybutadiene causes an increase in the thermal expansion of the cured product of the resin composition. Because of this, it has been difficult to satisfy both the superior dielectric characteristics and the low thermal expansion at the same time.

In view of the present circumstances as described above, an object of the present embodiment is to provide: a resin composition that is superior in dielectric characteristics and in a low thermal expansion; and a prepreg, a laminate, a resin film, a printed wiring board, and a semiconductor package, all of which use the said resin composition.

### [Means for Solving the Problems]

The inventors of the present invention studied to solve the problems described above, and as a result, they found that it was possible to solve the problems by the present embodiment described below.
[1] A resin composition containing:
   (A) a thermosetting resin,
   (B) one or more selected from the group consisting of a conjugated diene polymer and its derivative, having 2 or more of a functional group including an ethylenically unsaturated bond, and
   (C) an inorganic filler whose surface is treated with a silane coupling agent having a functional group including an ethylenically unsaturated bond.
[2] The resin composition according to [1], in which the component (A) is one or more selected from the group consisting of a maleimide resin having one or more of an N-substituted maleimide group and a derivative of the said maleimide resin.
[3] The resin composition according to [1] or [2], in which the component (B) is a resin having a vinyl group as the functional group including the ethylenically unsaturated bond.
[4] The resin composition according to any one of [1] to [3], in which the silane coupling agent having the functional group including the ethylenically unsaturated bond is a silane coupling agent having a vinyl group or a (meth)acryloyl group as the functional group including the ethylenically unsaturated bond.
[5] The resin composition according to any one of [1] to [4], in which the component (C) is a silica whose surface is treated with the silane coupling agent having the functional group including the ethylenically unsaturated bond.
[6] The resin composition according to any one of [1] to [5], in which the resin composition further contains (D) a styrene-based thermoplastic resin.
[7] The resin composition according to any one of [1] to [6], in which the resin composition further contains (E) a curing accelerator.
[8] A prepreg containing the resin composition according to any one of [1] to [7] or a semi-cured product of the resin composition.
[9] A laminate containing a cured product of the resin composition according to any one of [1] to [7] and metal foil.
[10] A resin film containing the resin composition according to any one of [1] to [7] or a semi-cured product of the resin composition.
[11] A printed wiring board containing a cured product of the resin composition according to any one of [1] to [7].
[12] A semiconductor package having the printed wiring board according to [11] and a semiconductor element.

### [Advantageous Effects of Invention]

According to the present embodiment, what is provided is: a resin composition that is superior in dielectric characteristics and in a low thermal expansion; and a prepreg, a laminate, a resin film, a printed wiring board, and a semiconductor package, all of which use the said resin composition.

### [Description of the Embodiment]

In this specification, the numeral range expressed by the word "to" indicates that the numerical value described before and after the word "to" is included as the minimum and maximum values, respectively.

For example, the expression of the numeral range by "X to Y" (X and Y are real numbers) means the numerical range of X or more and Y or less. The description "X or more" in this specification means the numerical value of X and the numerical value of more than X. In the same way, the description "Y or less" in this specification means the numerical value of Y and the numerical value of less than Y.

The upper and lower limits of the numeral range described in this specification may be arbitrarily combined with the upper and lower limits of other numeral range, respectively.

In the numeral range described in this specification, the upper and lower limit values of the numeral range may be substituted by the values described in Examples.

Each component and material described as an example in this specification may be used singly or in a combination of two or more of them, unless otherwise specifically mentioned. In this specification, the content of each component in the resin composition, in the case where a plurality of substances corresponding to each component is present in a resin composition, means a total amount of the components present in the resin composition, unless otherwise specifically mentioned.

In this specification, the term "solid content" means the components other than an organic solvent; thus, a component that is in the state of liquid at 25°C is regarded as the solid content.

"(Meth)acrylate" in this specification means an "acrylate" and a "methacrylate" corresponding to it. In the same way, "(meth)acryl" means an "acryl" and a "methacryl" corresponding to it, and "(meth)acryloyl means an "acryloyl" and a "methacryloyl" corresponding to it.

The number-average molecular weight (Mn) and the weight-average molecular weight (Mw) in this specification mean the values in terms of polystyrene measured by a gel permeation chromatography (GPC). Specifically, the number-average molecular weight (Mn) and the weight-average molecular weight (Mw) in this specification may be measured by the method described in Examples.

The term "semi-cured product" in this specification is the same meaning as the state of B-stage of a resin composition as defined in JIS K 6800 (2006), and the term "cured product" is the same meaning as the state of C-stage of a resin composition as defined in JIS K 6800 (2006).

The action mechanism described in this specification is mere presumption, thereby not limiting the mechanism that expresses the advantageous effects of the present embodiment.

Embodiments in any combination of the items described in this specification are included in the present embodiment.

### [Resin Composition]

The resin composition according to the present embodiment contains:
(A) a thermosetting resin,
(B) one or more selected from the group consisting of a conjugated diene polymer and its derivative, having 2 or more of a functional group including an ethylenically unsaturated bond, and
(C) an inorganic filler whose surface is treated with a silane coupling agent having a functional group including an ethylenically unsaturated bond.

In this specification, note that each component may be sometimes simply referred to as the component (A), the component (B), etc.; the same simplification may be applied to other components.

### <(A) Thermosetting Resin>

Examples of the thermosetting resin include an epoxy resin, a phenol resin, a maleimide resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. As the thermosetting resin (A), among these, from the viewpoints of a heat resistance and an adhesion to a conductor, one or more selected from the group consisting of an epoxy resin, a cyanate resin, and a maleimide resin are preferable, a maleimide resin is more preferable, and one or more of a resin selected from the group consisting of a maleimide resin having one or more of an N-substituted maleimide group and a derivative thereof (hereinafter, these are sometimes collectively referred to as "maleimide-based resin") are still more preferable.

The thermosetting resin (A) may be used singly, or in a combination of 2 or more of those described above.

In the description hereinafter, the maleimide resin having one or more of an N-substituted maleimide group is sometimes referred to as "maleimide resin (AX)" or "component (AX)".

The derivative of the maleimide resin having one or more of an N-substituted maleimide group is sometimes referred to as "maleimide resin derivative (AY)" or "component (AY)".

### (Maleimide Resin (AX))

There is no particular restriction in the maleimide resin (AX) as long as this is the maleimide resin having one or more of an N-substituted maleimide group.

From the viewpoints of an adhesion to a conductor and a heat resistance, the maleimide resin (AX) is preferably an aromatic maleimide resin having 2 or more of an N-substituted maleimide group, and more preferably an aromatic maleimide resin having two N-substituted maleimide groups.

In this specification, the term "aromatic maleimide resin" means the compound having an N-substituted maleimide group directly bonded to an aromatic ring. In this specification, the term "aromatic bismaleimide resin" means the compound having two N-substituted maleimide groups directly bonded to an aromatic ring. In this specification, the term "aromatic polymaleimide resin" means the compound having 3 or more N-substituted maleimide groups directly bonded to an aromatic ring. In this specification, the term "aliphatic maleimide resin" means the compound having an N-substituted maleimide group directly bonded to an aliphatic hydrocarbon.

As for the maleimide resin (AX), the maleimide resin represented by the following general formula (A-1) is preferable.

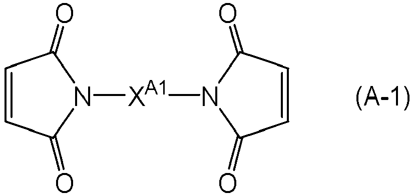

### (In the formula, X^{A1} represents a divalent organic group.)

In the above general formula (A-1), X^{A1} represents a divalent organic group.

Examples of the divalent organic group represented by X^{A1} in the above general formula (A-1) include a divalent organic group represented by the following general formula (A-2), a divalent organic group represented by the following general formula (A-3), a divalent organic group represented by the following general formula (A-4), a divalent organic group represented by the following general formula (A-5), a divalent organic group represented by the following general formula (A-6), and a divalent organic group represented by the following general formula (A-7). 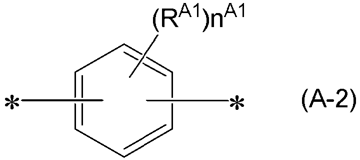 (In the formula, R^{A1} represents an aliphatic hydrocarbon group having the carbon number of 1 to 5 or a halogen atom, n^{A1} represents an integer of 0 to 4, and the symbol * represents a bonding site.)

Examples of the aliphatic hydrocarbon group having the carbon number of 1 to 5 represented by R^{A1} in the above general formula (A-2) include: alkyl groups having the carbon number of 1 to 5 such as a methyl group, an ethyl group, an n-propyl group, an isopropyl group, an n-butyl group, an isobutyl group, a t-butyl group, and an n-pentyl group; an alkenyl group having the carbon number of 2 to 5, and an alkynyl group having the carbon number of 2 to 5. The aliphatic hydrocarbon group having the carbon number of 1 to 5 may be any of a linear and a branched hydrocarbon group.

Examples of the halogen atom include a fluorine atom, a chlorine atom, a bromine atom, and an iodine atom.

In the above general formula (A-2), n^{A1} represents an integer of 0 to 4; from the viewpoint of an availability, this is preferably an integer of 0 to 2, more preferably 0 or 1, and still more preferably 0. When n^{A1} is an integer of 2 or more, a plurality of R^{A1} may be same or different with each other. 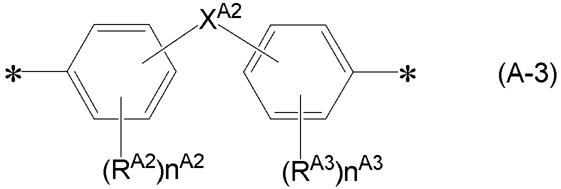 (In the formula, R^{A2} and R^{A3} each independently represent an aliphatic hydrocarbon group having the carbon number of 1 to 5 or a halogen atom. X^{A2} represents an alkylene group having the carbon number of 1 to 5, an alkylidene group having the carbon number of 2 to 5, an ether group, a sulfide group, a sulfonyl group, a carbonyloxy group, a keto group, a single bond, or a divalent organic group represented by the flowing general formula (A-3-1). Here, n^{A2} and n^{A3} reach independently represent an integer of 0 to 4, and the symbol * represents a bonding site.)

In the above general formula (A-3), the aliphatic hydrocarbon group having the carbon number of 1 to 5 and the halogen atom represented by R^{A2} and R^{A3} may be the same as those mentioned in R^{A1}.

Examples of the alkylene group having the carbon number of 1 to 5 represented by X^{A2} in the above general formula (A-3) include a methylene group, a 1,2-dimethylene group, a 1,3-trimethylene group, a 1,4-tetamethylene group, and 1,5-pentamethylene group. The alkylene group having the carbon number of 1 to 5 is preferably an alkylene group having the carbon number of 1 to 3, more preferably an alkylene group having the carbon number of 1 or 2, and still more preferably a methylene group.

Examples of the alkylidene group having the carbon number of 2 to 5 represented by X^{A2} in the above general formula (A-3) include an ethylidene group, a propylidene group, an isopropylidene group, a butylidene group, an isobutylidene group, a pentylidene group, and an isopentylidene group.

In the above general formula (A-3), n^{A2} and n^{A3} each independently represent an integer of 0 to 4. When n^{A2} or n^{A3} is an integer of 2 or more, a plurality of R^{A2} or a plurality of R^{A3} may be same or different with each other.

The divalent organic group of X^{A2} represented by the general formula (A-3-1) in the above general formula (A-3) is as follows. 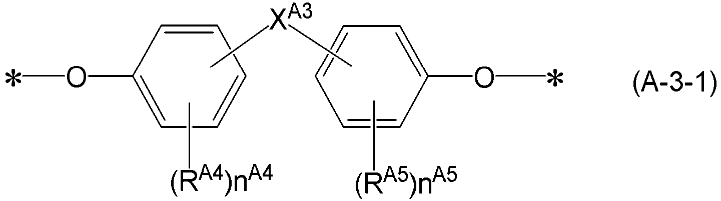 (In the formula, R^{A4} and R^{A5} each independently represent an aliphatic hydrocarbon group having the carbon number of 1 to 5 or a halogen atom. X^{A3} represents an alkylene group having the carbon number of 1 to 5, an alkylidene group having the carbon number of 2 to 5, an ether group, a sulfide group, a sulfonyl group, a carbonyloxy group, a keto group, or a single bond. Here, n^{A4} and n^{A5} reach independently represent an integer of 0 to 4, and the symbol * represents a bonding site.)

In the above general formula (A-3-1), the aliphatic hydrocarbon group having the carbon number of 1 to 5 and the halogen atom represented by R^{A4} and R^{A5} may be the same as those mentioned in R^{A1}.

In the above general formula (A-3-1), the alkylene group having the carbon number of 1 to 5 and the alkylidene group having the carbon number of 2 to 5 represented by X^{A3} may be the same as those mentioned in X^{A2}.

In the above general formula (A-3-1), n^{A4} and n^{A5} each independently represent an integer of 0 to 4; from the viewpoint of an availability, they are preferably an integer of 0 to 2, more preferably 0 or 1, and still more preferably 0. When n^{A4} or n^{A5} is an integer of 2 or more, a plurality of R^{A4} or a plurality of R^{A5} may be same or different with each other. 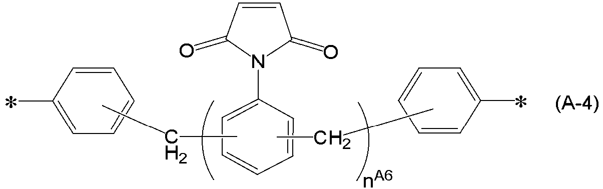 (In the formula, n^{A6} represents an integer of 0 to 10, and the symbol * represents a bonding site.) 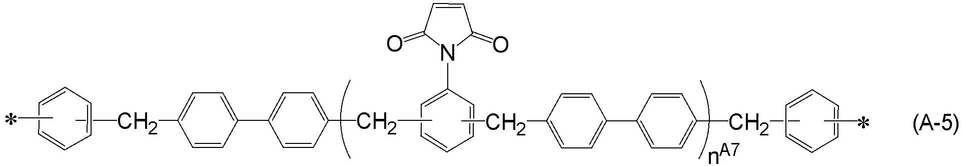 (In the formula, n^{A7} represents an integer of 0 to 5, and the symbol * represents a bonding site.) 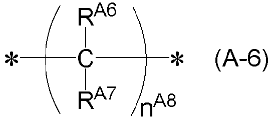 (In the formula, R^{A6} and R^{A7} each independently represent a hydrogen atom or an aliphatic hydrocarbon group having the carbon number of 1 to 5, n^{A8} represents an integer of 1 to 8, and the symbol * represents a bonding site.)

In the above general formula (A-6), the aliphatic hydrocarbon group having the carbon number of 1 to 5 and the halogen atom represented by R^{A6} and R^{A7} may be the same as those mentioned in R^{A1}.
When n^{A8} in the above general formula (A-6) is an integer of 2 or more, a plurality of R^{A6} or a plurality of R^{A7} may be same or different with each other. 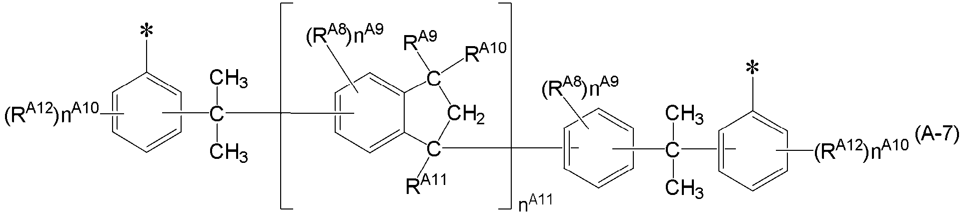 (In the formula, R^{A8} represents an alkyl group having the carbon number of 1 to 10, an alkyloxy group having the carbon number of 1 to 10, an alkylthio group having the carbon number of 1 to 10, an aryl group having the carbon number of 6 to 10, an aryloxy group having the carbon number of 6 to 10, an arylthio group having the carbon number of 6 to 10, a cycloalkyl group having the carbon number of 3 to 10, a halogen atom, a hydroxy group, or a mercapto group, and n^{A9} represents an integer of 0 to 3. R^{A9} to R^{A11} each independently represent an alkyl group having the carbon number of 1 to 10. R^{A12} each independently represent an alkyl group having the carbon number of 1 to 10, an alkyloxy group having the carbon number of 1 to 10, an alkylthio group having the carbon number of 1 to 10, an aryl group having the carbon number of 6 to 10, an aryloxy group having the carbon number of 6 to 10, an arylthio group having the carbon number of 6 to 10, a cycloalkyl group having the carbon number of 3 to 10, a halogen atom, a nitro group, a hydroxy group, or a mercapto group; n^{A10} each independently represent an integer of 0 to 4, and n^{A11} represent a numerical value of 0.95 to 10.0; and the symbol * represents a bonding site.)

Examples of the alkyl group having the carbon number of 1 to 10 represented by R^{A8} in the above general formula (A-7) include a methyl group, an ethyl group, a propyl group, a butyl group, a pentyl group, a hexyl group, a heptyl group, an octyl group, and a decyl group. These may be any of a liner and a branched alkyl group.

The alkyl group included in the alkyloxy group having the carbon number of 1 to 10 and in the alkylthio group having the carbon number of 1 to 10 represented by R^{A8} may be the same as those previously mentioned in the alkyl group having the carbon number of 1 to 10.

Examples of the aryl group having the carbon number of 6 to 10 represented by R^{A8} include a phenyl group and a naphthyl group.

The aryl group included in the aryloxy group having the carbon number of 6 to 10 and in the arylthio group having the carbon number of 6 to 10 represented by R^{A8} may be the same as those previously mentioned in the aryl group having the carbon number of 6 to 10.

Examples of the cycloalkyl group having the carbon number of 3 to 10 represented by R^{A8} include a cyclopropyl group, a cyclobutyl group, a cyclopentyl group, a cyclohexyl group, a cycloheptyl group, a cyclooctyl group, and a cyclodecyl group.

The alkyl group having the carbon number of 1 to 10 represented by R^{A9} to R^{A11} may be the same as those mentioned in R^{A8}. Among these, R^{A9} to R^{A11} are preferably an alkyl group having the carbon number of 1 to 4, more preferably a methyl group and an ethyl group, and still more preferably a methyl group.

In the above general formula (A-7), n^{A9} is an integer of 0 to 3. When n^{A9} is 2 or 3, a plurality of R^{A8} may be same or different with each other.

Among those mentioned above, from the viewpoints of a compatibility with other resins, a solvability to a solvent, dielectric characteristics, an adhesion to a conductor, and a productivity, the divalent organic group represented by the above general formula (A-7) is preferably the divalent organic group in which n^{A9} is zero and R^{A9} to R^{A11} are a methyl group.

In the above general formula (A-7), a plurality of R^{A8}, a plurality of R^{A12}, a plurality of n^{A9}, and a plurality of n^{A10} each may be same or different with each other. When n^{A11} is more than 1, a plurality of R^{A9}, a plurality of R^{A10}, and a plurality of R^{A11} each may be same or different with each other.

Explanation about the alkyl group having the carbon number of 1 to 10, the alkyloxy group having the carbon number of 1 to 10, the alkylthio group having the carbon number of 1 to 10, the aryl group having the carbon number of 6 to 10, the aryloxy group having the carbon number of 6 to 10, the arylthio group having the carbon number of 6 to 10, and the cycloalkyl group having the carbon number of 3 to 10, all of which are represented by R^{A12} in the above general formula (A-7), is the same as the explanation about the alkyl group having the carbon number of 1 to 10, the alkyloxy group having the carbon number of 1 to 10, the alkylthio group having the carbon number of 1 to 10, the aryl group having the carbon number of 6 to 10, the aryloxy group having the carbon number of 6 to 10, the arylthio group having the carbon number of 6 to 10, and the cycloalkyl group having the carbon number of 3 to 10, all of which are represented by the above-mentioned R^{A8}.

Among those mentioned above, from the viewpoints of a compatibility with other resins, a solvability to a solvent, dielectric characteristics, an adhesion to a conductor, and a productivity, R^{A12} is preferably an alkyl group having the carbon number of 1 to 4, a cycloalkyl group having the carbon number of 3 to 6, an aryl group having the carbon number of 6 to 10; an alkyl group having the carbon number of 1 to 3 is more preferable.

In the above general formula (A-7), n^{A10} is an integer of 0 to 4; from the viewpoints of a compatibility with other resins, a solvability to a solvent, dielectric characteristics, an adhesion to a conductor, and a productivity, this value is preferably an integer of 0 to 3, more preferably 0 or 2.

In the above general formula (A-7), from the viewpoints of a compatibility with other resins, a solvability to a solvent, dielectric characteristics, an adhesion to a conductor, and a productivity, n^{A11} is preferably 0.98 to 8.0, more preferably 1.0 to 7.0, and still more preferably 1.1 to 6.0.

The divalent organic group represented by the above general formula (A-7) is preferably the divalent organic group represented by the following general formula (A-7-1), the divalent organic group represented by the following general formula (A-7-2), the divalent organic group represented by the following general formula (A-7-3), and the divalent organic group represented by the following general formula (A-7-4), among others. 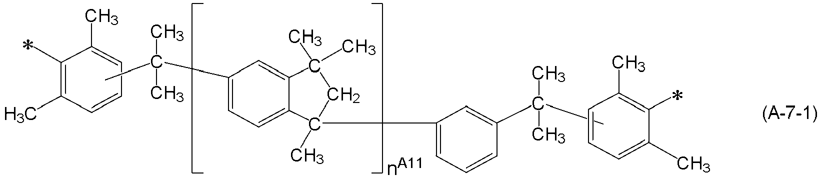 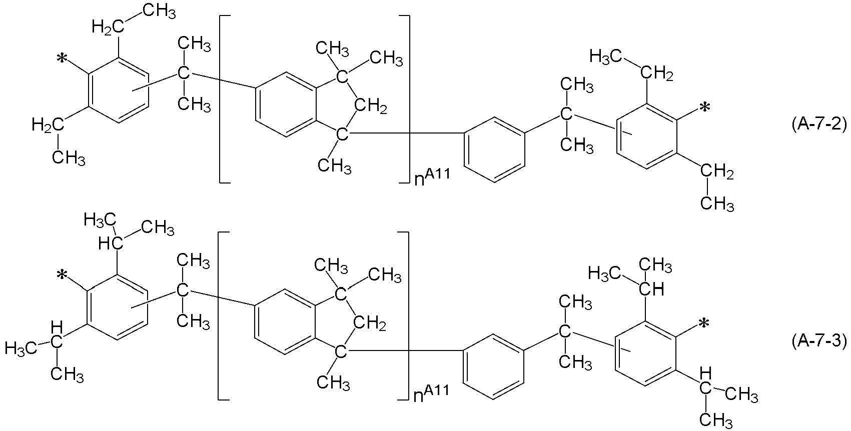 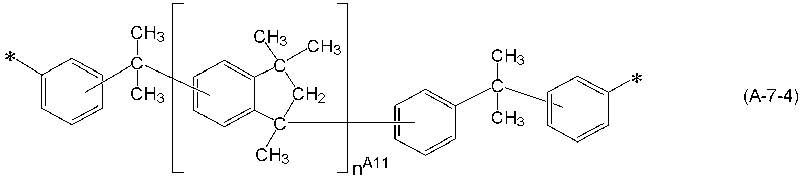 (In these formulae, n^{A11} is the same as those in the above general formula (A-7); the symbol * represents a bonding site.)

Among the maleimide resins represented by the above general formula (A-1), the maleimide resin having, as X^{A1}, a divalent organic group represented by the above general formula (A-3) (hereinafter, this is sometimes referred to as "maleimide resin (i)") and the maleimide resin having, as X^{A1}, a divalent organic group represented by the above general formula (A-7) (hereinafter, this is sometimes referred to as "maleimide resin (ii)") are preferable, and a combination of the maleimide resin (i) and the maleimide resin (ii) is more preferable.

When the maleimide resin (i) and the maleimide resin (ii) are used together, the content ratio of the maleimide resin (i) and the maleimide resin (ii) [(i):(ii)] is not particularly restricted; and is preferably in the range of 2:98 to 60:40, more preferably in the range of 5:95 to 50:50, and still more preferably in the range of 10:90 to 40:60, from the viewpoints of dielectric characteristics and a low thermal expansion, the content ratio on the mass basis.

Illustrative examples of the maleimide resin (AX) include an aromatic bismaleimide resin, an aromatic polymaleimide resin, and an aliphatic maleimide resin; among these, an aromatic bismaleimide resin is preferable.

Specific examples of the maleimide resin (AX) include bis(4-maleimidophenyl)methane, m-phenylene bismaleimide, 2,2-bis[4-(4-maleimidophenoxy)phenyl]propane, 4-methyl-1,3-phenylene bismaleimide, 3,3'-dimethyl-5,5'-diethyl-4,4'-diphenylmethane bismaleimide, polyphenylmethane maleimide, a biphenylaralkyl type maleimide, and an aromatic bismaleimide resin having an indane skeleton. Among these, bis(4-maleimidophenyl)methane and an aromatic bismaleimide resin having an indane skeleton are preferable.

### (Maleimide Resin Derivative (AY))

As for the maleimide resin derivative (AY), a resin containing a structure derived from a maleimide resin having one or more of an N-substituted maleimide group (i.e., the above-mentioned maleimide resin (AX)) and a structure derived from a diamine compound is preferable (hereinafter, this is sometimes referred to as "aminomaleimide resin").

As for the structure derived from the maleimide resin (AX) contained in the aminomaleimide resin, for example, the structure formed by the Michael addition reaction in which at least one N-substituted maleimide group among the N-substituted maleimide groups that are contained in the maleimide resin (AX) is reacted with an amino group contained in the diamine compound may be mentioned.

The structure derived from the maleimide resin (AX) contained in the aminomaleimide resin may be one structure, or two or more structures.

As for the structure derived from the diamine compound contained in the aminomaleimide resin, for example, the structure formed by the Michael addition reaction in which one or both amino groups of the two amino groups that are contained in the diamine compound is reacted with an N-substituted maleimide group contained in the maleimide resin (AX) may be mentioned.

The structure derived from the diamine compound contained in the aminomaleimide resin may be one structure, or two or more structures.

The amino group contained in the diamine compound is preferably a primary amino group.

As for the diamine compound, an aromatic diamine compound having 2 amino groups that are directly bonded to an aromatic ring and a silicone compound having 2 primary amino groups are preferable.

Examples of the aromatic diamine compound include 4,4'-diaminodiphenylmethane, 3,3'-dimethyl-4,4'-diaminodiphenylmethane, 3,3'-diethyl-4,4'-dimainodiphenylmethane, 2,2-bis[4-(4-aminophenoxy)phenyl]propane, 4,4'-[1,3-phenylenebis(1-methylethylidene)bisaniline, 4,4'-[1,4-phenylenebis(1-methylethylidene)bisaniline, and 3,3'-diethyl-4,4'-diaminodiphenylmethane.

### (Content of Thermosetting Resin (A))

The content of the thermosetting resin (A) in the resin composition of the present embodiment is not particularly limited, and is preferably in the range of 5 to 60 mass%, more preferably in the range of 10 to 50 mass%, and still more preferably in the range of 20 to 40 mass% with respect to the total amount (100 mass%) of the resin components in the resin composition of the present embodiment.

When the content of the thermosetting resin (A) is equal to or more than the lower limit value, a heat resistance, a moldability, a processability, and an adhesion to a conductor are prone to be enhanced. When the content of the thermosetting resin (A) is equal to or less than the upper limit value, dielectric characteristics are prone to be further enhanced.

In this specification, the term "resin component" means a resin and a compound that forms a resin by a curing reaction.

In the resin composition of the present embodiment, the resin component corresponds, for example, the component (A), the component (B), and the component (D).

When the resin composition of the present embodiment includes, as an optional component, a resin other than the above-mentioned components or a compound that forms a resin by a curing reaction, such an optional component is included in the resin component.

On the other hand, the component (C) and the component (E) are not included in the resin composition.

The content of the resin component in the resin composition of the present embodiment is not particularly limited, and is preferably in the range of 10 to 70 mass%, more preferably in the range of 20 to 60 mass%, and still more preferably in the range of 30 to 50 mass% with respect to a total solid content (100 mass%) of the resin composition of the present embodiment.

When the content of the resin component is equal to or more than the lower limit value, a heat resistance, a moldability, a processability, and an adhesion to a conductor are prone to be enhanced. When the content of the resin component is equal to or less than the upper limit value, a low thermal expansion is prone to be further enhanced.

The content of the maleimide-based resin in the thermosetting resin (A) is not particularly limited, and is preferably in the range of 80 to 100 mass%, more preferably in the range of 90 to 100 mass%, and still more preferably in the range of 95 to 100 mass% with respect to the total amount (100 mass%) of the thermosetting resin (A).

When the content of the maleimide-based resin is equal to or more than the lower limit value, a heat resistance, a moldability, a processability, and an adhesion to a conductor are prone to be enhanced. When the content of the maleimide-based resin is equal to or less than the upper limit value, dielectric characteristics are prone to be further enhanced.

### <(B) One or More Selected from the Group Consisting of a Conjugated Diene Polymer and Its Derivative, Having 2 or More of a Functional Group Including an Ethylenically Unsaturated Bond>

When the resin composition of the present embodiment includes the component (B), dielectric characteristics thereof may be enhanced.

The component (B) may be used singly or in a combination of two or more of it.

In this specification, the term "ethylenically unsaturated bond" means a carbon-carbon conjugated double bond that is capable of undergoing an addition reaction, not including a conjugated double bond in an aromatic ring.

In this specification, hereinafter, the functional group including the ethylenically unsaturated bond is sometimes referred to as "ethylenically unsaturated group".

Examples of the ethylenically unsaturated group that is possessed by the component (B) include a vinyl group, an allyl group, a 1-methylallyl group, an isopropenyl group, a 2-butenyl group, a 3-butenyl group, a styryl group, an N-substituted maleimide group, and a (meth)acryloyl group. Among these, the component (B) is preferably those having a vinyl group or an N-substituted maleimide group, and more preferably those having a vinyl group, as the functional group including the ethylenically unsaturated bond.

Hereinafter, as the component (B), the conjugated diene polymer having 2 or more functional groups including the ethylenically unsaturated bond (hereinafter, this is sometimes referred to as "diene polymer (B1)" and the resin that is a derivative of the conjugated diene polymer (B1) and has 2 or more functional groups including the ethylenically unsaturated bond (hereinafter, this is sometimes referred to as "modified diene polymer (B1)") will be specifically described.

### (Conjugated Diene Polymer (B1))

In this specification, the term "conjugated diene polymer" means a polymer of a conjugated diene compound.

Examples of the conjugated diene compound that is a monomer component of the conjugated diene polymer (B1) include 1,3-butadiene, isoprene, 1,3-pentadiene, 2,3-dimethyl-1,3-butadiene, 2-phenyl-1,3-butadiene, and 1,3-hexadiene.

The conjugated diene polymer (B1) may be a polymer of one conjugated diene compound or a copolymer of two or more conjugated diene compounds.

The conjugated diene polymer (B1) may be a polymer of one conjugated diene compound or a copolymer with one or more monomer other than the conjugated diene compound.

When the conjugated diene polymer (B1) is the copolymer, there is no particular restriction in the polymerization style thereof; thus, it may be any of a random copolymer, a block copolymer, and a graft copolymer.

As for the conjugated diene polymer (B1), from the viewpoints of a compatibility with other resins and dielectric characteristics, a conjugated diene polymer having a vinyl group at its side chain is preferable.

The number of the side-chain vinyl group in one molecule of the conjugated diene polymer (B1) is not particularly limited, and is preferably 2 or more, more preferably 5 or more, and still more preferably 10 or more, from the viewpoints of a compatibility with other resins and dielectric characteristics.

There is no particular restriction in the upper limit of the number of the side-chain vinyl group in one molecule of the conjugated diene polymer (B1); thus, this may be, for example, 100 or less, 80 or less, or 60 or less.

Examples of the conjugated diene polymer (B1) include a polybutadiene having a 1,2-vinyl group and a butadiene-styrene copolymer having a 1,2-vinyl group. Among these, from the viewpoints of dielectric characteristics and a heat resistance, a polybutadiene having a 1,2-vinyl group and a butadiene-styrene copolymer having a 1,2-vinyl group are preferable, and a polybutadiene having a 1,2-vinyl group is more preferable. As for the polybutadiene having a 1,2-vinyl group, a polybutadiene homopolymer having a 1,2-vinyl group is preferable.

The 1,2-vinyl group derived from the butadiene in the conjugated diene polymer (B1) is the vinyl group included in the structural unit derived from the butadiene represented by the following formula (B1-1).

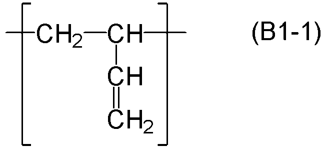

When the conjugated diene polymer (B1) is the polybutadiene having a 1,2-vinyl group, there is no particular restriction in the content of the structural unit having the 1,2-vinyl group relative to the total structural units derived from the butadiene that makes up the polybutadiene (hereinafter, this is sometimes referred to as "vinyl group content"). From the viewpoints of a compatibility with other resins, dielectric characteristics, and a heat resistance, this is preferably 50% by mole or more, more preferably 70% by mole or more, and still more preferably 85% by mole or more. There is no particular restriction in the upper limit of the vinyl group content; thus, this may be 100% by mole or less, 95% by mole or less, or 90% by mole or less. As for the structural unit having the 1,2-vinyl group, the structural unit derived from the butadiene represented by the above formula (B1-1) is preferable.

From the same viewpoints, the polybutadiene having the 1,2-vinyl group is preferably a 1,2-polybutadiene homopolymer.

### (Modified Conjugated Diene Polymer (B2))

The modified conjugated diene polymer (B2) is the polymer having the conjugated diene polymer modified.

Owing to containing the modified diene polymer (B2), the resin composition of the present embodiment is prone to have further enhanced dielectric characteristics while being superior in a heat resistance and a low thermal expansion.

As for the modified diene polymer (B2), from the viewpoints of a compatibility with other resins, dielectric characteristics, and an adhesion to a conductor, a modified conjugated diene polymer in which the conjugated diene polymer having a side-chain vinyl group is modified with a maleimide resin having 2 or more N-substituted maleimide groups (hereinafter, this is sometimes referred to as "maleimide resin for modification") is preferable.

As for the conjugated diene polymer having a side-chain vinyl group, the conjugated diene polymer having a side-chain vinyl group that has been explained as the conjugated diene polymer (B1) may be used; the same is applied to a preferable embodiment thereof.

The conjugated diene polymer having a side-chain vinyl group may be used singly or in a combination of two or more of it.

As for the maleimide resin for modification, for example, the maleimide resin having 2 or more N-substituted maleimide groups that has been described as the component (A) may be used; the same is applied to a preferable embodiment thereof.

The maleimide resin for modification may be used singly or in a combination of two or more of it.

The modified conjugated diene polymer (B2) is preferably the polymer having, in its side chain, a substituent that is formed by reacting the side-chain vinyl group in the conjugated diene polymer having the side-chain vinyl group with the N-substituted maleimide group in the maleimide resin for modification (hereinafter, this substituent is sometimes referred to as "maleimide resin-derived substituent"); it is more preferable to have both the maleimide resin-derived substituent and the vinyl group in the side chain. In this case, the modified conjugated diene polymer (B2) has the N-substituted maleimide group and the vinyl group as the ethylenically unsaturated groups.

From the viewpoints of a compatibility with other resins, dielectric characteristics, a low thermal expansion, and a heat resistance, the substituent derived from the maleimide resin is preferably the group including a structure represented by the following general formula (B2-1) or (B2-2) as the structure derived from the maleimide resin having 2 or more N-substituted maleimide groups. 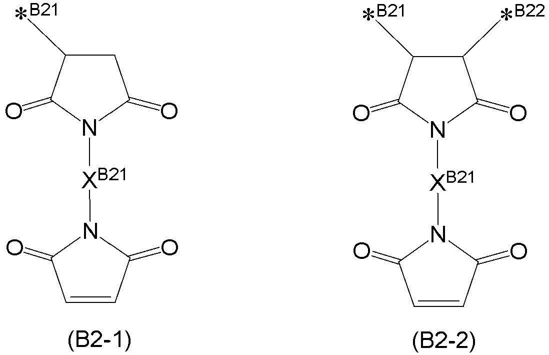 (In the formula, X^{B21} represents a divalent group having 2 N-substituted maleimide groups removed from the maleimide resin having 2 or more N-substituted maleimide groups; the symbol *^{B21} represents a bonding site to a carbon atom that is derived from the side-chain vinyl group of the conjugated diene polymer having the side-chain vinyl group; and the symbol *^{B22} represents a bonding site to other atoms.)

The presence degree of the group derived from the maleimide resin for modification in the modified diene polymer (B2) may be determined by the modification index that indicates the modification degree of the vinyl group in the conjugated diene polymer having the side-chain vinyl group by the maleimide resin for modification (hereinafter, this is sometimes referred to as "vinyl group modification rate").

The vinyl group modification rate is not particularly limited, and is preferably in the range of 20 to 70%, more preferably in the range of 30 to 60%, and still more preferably in the range of 35 to 50%, from the viewpoints of a compatibility with other resins, dielectric characteristics, a low thermal expansion, and a heat resistance. The vinyl group modification rate is the value obtained by the method described in Examples.

There is no particular restriction in the reaction condition of the conjugated diene polymer (B1) with the maleimide resin for modification. For example, the modified conjugated diene polymer (B2) may be obtained by charging raw materials and an organic solvent, which is then followed by the reaction with heating, stirring, and the like as needed.

In the above-mentioned reaction, there is no particular restriction in the ratio (Mm/Mv) of the mole number (Mm) of the N-substituted maleimide group in the maleimide resin for modification to the mole number (Mv) of the side-chain vinyl group in the conjugated diene polymer having the side-chain vinyl group. From the viewpoints of a compatibility of the resulting modified conjugated diene polymer (B2) with other resins and of suppressing gelation of the resulting product, the ratio is preferably in the range of 0.001 to 0.5, more preferably in the range of 0.005 to 0.1, and still more preferably in the range of 0.008 to 0.05.

The number-average molecular weight is not particularly limited, and is preferably in the range of 700 to 6,000, more preferably in the range of 800 to 5,000, and still more preferably in the range of 1,000 to 2,500, from the viewpoints of a compatibility with other resins, dielectric characteristics, a low thermal expansion, and a heat resistance.

The content of the component (B) in the resin composition of the present embodiment is not particularly limited, and is preferably in the range of 10 to 60 mass%, more preferably in the range of 15 to 50 mass%, and still more preferably in the range of 20 to 40 mass% with respect to the total amount (100 mass%) of the resin components in the resin composition of the present embodiment.

When the content of the component (B) is equal to or more than the lower limit value, dielectric characteristics are prone to be further enhanced. When the content of the component (B) is equal to or less than the upper limit value, a heat resistance and a flame retardancy are prone to be further enhanced.

### <(C) Inorganic Filler Whose Surface is Treated with a Silane Coupling Agent Having a Functional Group Including an Ethylenically Unsaturated Bond>

In the resin composition of the present embodiment, dielectric characteristics and a low thermal expansion are enhanced when containing as the component (C) an inorganic filler whose surface is treated with a silane coupling agent having a functional group including an ethylenically unsaturated bond (hereinafter, this is sometimes referred to simply as a "silane coupling agent"). The reason for this is not clear, but is presumed as follows.

The component (C) that is contained in the resin composition of the present embodiment is treated on its surface with the silane coupling agent having an ethylenically unsaturated group. Because of this, the ethylenically unsaturated group that is present on the surface of the component (C) is susceptible to the reaction with the ethylenically unsaturated group in the component (B), resulting in increase of the crosslinking point between the component (B) and the component (C). As a result, it is presumed that the thermal expansion of the component (B) that has a relatively high thermal expansion is restricted by crosslinking with the component (C) that has a relatively low thermal expansion, thereby resulting in decrease of the thermal expansion of the whole cured product. In addition, it is presumed that because the ethylenically unsaturated group has a low polarity and is sufficient when it is present only on the surface of the inorganic filler, the effect on the dielectric characteristics is so small that the dielectric characteristics thereof may be kept well.

The component (C) may be used singly or in a combination of 2 or more of it.

Examples of the inorganic filler include silica, alumina, titanium oxide, mica, beryllia, barium titanate, potassium titanate, strontium titanate, calcium titanate, aluminum carbonate, calcium carbonate, magnesium hydroxide, aluminum hydroxide, aluminum silicate, calcium silicate, magnesium silicate, silicon nitride, boron nitride, clay, talc, aluminum borate, and silicon carbide. Among these, from the viewpoints of a low thermal expansion, a heat resistance, and a flame retardancy, silica, alumina, mica, and talc are preferable, silica and alumina are more preferable, and silica is still more preferable. In other words, the component (C) is preferably the silica whose surface is treated with the silane coupling agent having the functional group including an ethylenically unsaturated bond. As for the silica, from the viewpoints of dispersibility and moldability, a fused silica is preferable.

Examples of the ethylenically unsaturated group in the silane coupling agent include a vinyl group, an allyl group, a 1-methylallyl group, an isopropenyl group, a 2-butenyl group, a 3-butenyl group, a styryl group, an N-substituted maleimide group, and a (meth)acryloyl group. Among these, from the viewpoints of dielectric characteristics and a low thermal expansion, the silane coupling agent having a vinyl group or a (meth)acryloyl group is preferable, and the silane coupling agent having a vinyl group is more preferable, as the functional group including the ethylenically unsaturated bond. The ethylenically unsaturated group in the silane coupling agent is preferably the same as the ethylenically unsaturated group in the component (B); it is more preferable that both the silane coupling agent to be used for surface-treatment of the inorganic filler and the component (B) have a vinyl group as the ethylenically unsaturated group.

The number of the ethylenically unsaturated group in one molecule of the silane coupling agent is not particularly limited, and is preferably in the range of 1 to 3, more preferably 1 or 2, and still more preferably 1.

Examples of the silane coupling agent having the ethylenically unsaturated group include: silane coupling agents having a vinyl group as the ethylenically unsaturated group, such as vinyl trimethoxysilane, vinyl triethoxysilane, vinyl methyldimethoxysilane, and vinyl methyldiethoxysilane; and silane coupling agents having a (meth)acryloxy group as the ethylenically unsaturated group, such as γ-methacryloxypropyl trimethoxysilane, γ-methacryloxypropyl triethoxysilane, γ-methacryloxypropyl methyldimethoxysilane, γ-methacryloxypropyl methyldimethoxysilane, γ-acryloxypropyl trimethoxysilane, γ-acryloxypropyl triethoxysilane, γ-acryloxypropyl methyldimethoxysilane, and γ-acryloxypropyl methyldiethoxysilane. Among these, from the viewpoints of dielectric characteristics and a low thermal expansion, a silane coupling agent having a vinyl group is preferable.

The silane coupling agent having the ethylenically unsaturated group may be used singly or in a combination of 2 or more of it.

Surface treatment of the inorganic filler by the silane coupling agent having the ethylenically unsaturated group may be conducted with a known method. Specifically, for example, the inorganic filler may be surface-treated with a dry method or with a wet method using the silane coupling agent having the ethylenically unsaturated group.

The average particle diameter (D₅₀) of the component (C) is not particularly limited, and is preferably in the range of 0.01 to 20 µm, more preferably in the range of 0.1 to 10 µm, still more preferably in the range of 0.2 to 1 µm, and especially preferably in the range of 0.3 to 0.8 µm, from the viewpoints of dispersibility of the component (C) and of fine wiring, the average particle diameter.

In this specification, the average particle diameter (D₅₀) of the component (C) is the particle diameter at the point corresponding to the 50% volume in the cumulative frequency distribution curve of the particle diameter based on the 100% as the total volume of the particle. The average particle diameter of the component (C) may be measured by using, for example, a particle size distribution measurement instrument with a laser diffraction scattering method.

The component (C) may be, for example, a spherical form or a crushed form; a spherical form is preferable.

The content of the component (C) in the resin composition of the present embodiment is not particularly limited, and is preferably in the range of 20 to 80 mass%, more preferably in the range of 30 to 70 mass%, and still more preferably in the range of 40 to 60 mass% with respect to a total solid content (100 mass%) of the resin composition of the present embodiment.

When the content of the component (C) is equal to or more than the lower limit value, a low thermal expansion and a heat resistance are prone to be enhanced. When the content of the component (C) is equal to or less than the upper limit value, a moldability and an adhesion to a conductor are prone to be further enhanced.

### <(D) Styrene-based Thermoplastic Resin>

It is preferable that the resin composition of the present embodiment further contains a styrene-based thermoplastic resin (D).

The resin composition of the present embodiment is prone to have further enhanced dielectric characteristics by containing the styrene-based thermoplastic resin (D).

The styrene-based thermoplastic resin (D) may be used singly or in a combination of 2 or more of it.

There is no particular restriction in the styrene-based thermoplastic resin (D) as far as it is a thermoplastic resin having a structural unit derived from a styrenic compound.

The styrene-based thermoplastic resin (D) has a structural unit derived from a styrenic compound. Examples of the styrenic compound include: styrene; and alkyl-substituted styrenes such as α-methylstyrene, o-methylstyrene, m-methylstyrene, and p-methylstyrene. The number of the carbon number of the alkyl group in the alkyl-substituted styrene is not particularly limited, and is preferably in the range of 1 to 5, more preferably in the range of 1 to 3, and still more preferably 1 or 2.

The styrene-based thermoplastic resin (D) may contain a structural unit other than the structural unit derived from the styrenic compound.

Examples of the structural unit other than the structural unit derived from the styrenic compound that may be contained in the styrene-based thermoplastic resin (D) include a structural unit derived from butadiene, a structural unit derived from isoprene, a structural unit derived from maleic acid, and a structural unit derived from maleic anhydride.

The structural unit derived from butadiene and the structural unit derived from isoprene may be hydrogenated. When hydrogenated, the structural unit derived from butadiene is a mixed structural unit of an ethylene unit and a butylene unit, and the structural unit derived from isoprene is a mixed structural unit of an ethylene unit and a propylene unit.

Examples of the styrene-based thermoplastic resin (D) include a hydrogenated product of styrene-butadiene-styrene block copolymer, a hydrogenated product of styrene-isoprene-styrene block copolymer, and styrene-maleic anhydride copolymer.

As for the hydrogenated styrene-butadiene-styrene block copolymer, SEBS that is formed by completely hydrogenating the carbon-carbon conjugated double bond in the butadiene block and SBBS that is formed by partially hydrogenating the carbon-carbon conjugated double bond at the 1,2-bonding site in the butadiene block may be mentioned. The hydrogenated styrene-isoprene-styrene block copolymer is formed as SEPS by hydrogenating the polyisoprene portion. Among these, from the viewpoints of dielectric characteristics, an adhesion to a conductor, a heat resistance, a glass transition temperature, and a low thermal expansion, SEBS and SEPS are preferable, and SEBS is more preferable.

The content of the structural unit derived from the styrenic compound in the styrene-based thermoplastic resin (D) (hereinafter, this is sometimes referred to as "styrene content") is not particularly limited, and is preferably in the range of 5 to 60 mass%, more preferably in the range of 10 to 50 mass%, and still more preferably in the range of 15 to 40 mass%, from the viewpoints of dielectric characteristics, an adhesion to a conductor, a heat resistance, a glass transition temperature, and a low thermal expansion, the styrene content.

The weight-average molecular weight (Mw) of the styrene-based thermoplastic resin (D) is not particularly limited, and is preferably in the range of 10,000 to 500,000, more preferably in the range of 50,000 to 350,000, and still more preferably in the range of 60,000 to 200,000.

When the resin composition of the present embodiment contains the styrene-based thermoplastic resin (D), the content of the styrene-based thermoplastic resin (D) is not particularly limited, and is preferably in the range of 10 to 80 mass%, more preferably in the range of 20 to 60 mass%, and still more preferably in the range of 30 to 50 mass% with respect to the total amount (100 mass%) of the resin components in the resin composition of the present embodiment.

When the content of the styrene-based thermoplastic resin (D) is equal to or more than the lower limit value, dielectric characteristics are prone to be enhanced. When the content of the styrene-based thermoplastic resin (D) is equal to or less than the upper limit value, a heat resistance and a flame retardancy are prone to be enhanced.

### ((E) Curing Accelerator)

It is preferable that the resin composition of the present embodiment further contains a curing accelerator (E).

The resin composition of the present embodiment containing the curing accelerator (E) enhances a curing property thereof, so that dielectric characteristics, a heat resistance, and an adhesion to a conductor are prone to be further enhanced.

The curing accelerator (E) may be used singly or in a combination of 2 or more of it.

Examples of the curing accelerator (E) include: acid catalysts such as p-toluenesulfonic acid; amine compounds such as triethylamine, tributylamine, pyridine, and dicyandiamide; imidazole compounds such as methylimidazole, phenylimidazole, 2-undecylimidazole, 1-cyanoethyl-2-phenylimidazole, 1-cyanoethyl-2-phenylimidazolium trimellitate, and isocyanate-masked imidazole; quaternary ammonium compounds; phosphorous compounds such as triphenylphosphine and an addition reaction product of p-benzoquinone with tri-n-butylphosphine, which is a tertiary phosphonium compound; organic peroxides such as dicumyl peroxide, 2,5-dimethyl-2,5-bis(t-butylperoxy)hexyne-3, 2,5-dimethyl-2,5-bis(t-butylperoxy)hexane, t-butylperoxyisopropyl monocarbonate, and α,α'-bis(t-butylperoxy)diisopropylbenzene; inorganic peroxide; azo compounds; carboxylate salts of manganese, cobalt, zinc, or the like; acid catalysts such as p-toluenesulfonic acid. Among these, organic peroxides and imidazole compounds are preferable; α,α'-bis(t-butylperoxy)diisopropylbenzene and isocyanate-masked imidazole are more preferable; a combination of these compounds is still more preferable.

When the resin composition of the present embodiment contains the curing accelerator (E), the content of the curing accelerator (E) is not particularly limited, and is preferably in the range of 0.1 to 10 parts by mass, more preferably in the range of 0.5 to 8 parts by mass, and still more preferably in the range of 1 to 6 parts by mass with respect to 100 parts by mass of the thermosetting resin (A).

When the content of the curing accelerator (E) is equal to or more than the lower limit value, a sufficient curing acceleration effect is prone to be obtained. When the content of the curing accelerator (E) is equal to or less than the upper limit value, a storage stability is prone to be further enhanced.

### <(F) Flame Retardant>

It is preferable that the resin composition of the present embodiment further contains a flame retardant (F).

When the resin composition of the present embodiment contains the flame retardant (F), a flame retardancy of the resin composition is prone to be further enhanced.

The flame retardant (F) may be used singly or in a combination of 2 or more of it, and may further contain a flame retardant adjuvant as needed.

Examples of the flame retardant (F) include a phosphorous-based flame retardant, a metal hydroxide, and a halogen-based flame retardant.

Examples of the halogen-based flame retardant include a chlorine-based flame retardant and a bromine-based flame retardant. Among these, a bromine-based flame retardant is preferable.

### (Content of the Flame Retardant (F))

When the resin composition of the present embodiment contains the flame retardant (F), the content of the flame retardant (F) is preferably in the range of 1 to 50 parts by mass, more preferably in the range of 10 to 45 parts by mass, and still more preferably in the range of 30 to 40 parts by mass with respect to 100 parts by mass of the resin components in the resin composition of the present embodiment from the viewpoints of a flame retardancy and a moldability.

### <Other Components>

The resin composition of the present embodiment may further contain, as needed, one or more additives selected from the group consisting of a resin material other than those components described above, an antioxidant, a heat stabilizer, an antistatic agent, a UV absorber, a pigment, a colorant, a lubricant, and other additives. Each of them may be used singly or in a combination of 2 or more of them. There is no particular restriction in the use amount of them; thus, they may be used as needed within the range not impair the advantageous effects of the present embodiment.

### (Organic Solvent)

From the viewpoints of an ease in handling and a productivity of a prepreg to be described later, the resin composition of the present embodiment may contain an organic solvent.

The organic solvent may be used singly or in a combination of 2 or more of it.

Examples of the organic solvent include: alcoholic solvents such as ethanol, propanol, butanol, methyl cellosolve, butyl cellosolve, and propyleneglycol monomethyl ether; ketonic solvents such as acetone, methyl ethyl ketone, methyl isobutyl ketone, and cyclohexanone; ether type solvents such as tetrahydrofuran; aromatic hydrocarbon solvents such as toluene, xylene, and mesitylene; nitrogen atom-containing solvents such as dimethyl formaldehyde, dimethyl acetamide, and N-methyl pyrrolidone; sulfur atom-containing solvents such as dimethyl sulfoxide; and ester type solvents such as γ-butyrolactone.

Among these, from the viewpoint of solvability, alcoholic solvents, ketonic solvents, nitrogen atom-containing solvents, and aromatic hydrocarbon solvents are preferable, ketonic solvents are more preferable, and methyl ethyl ketone is still more preferable.

### <Production Method of the Resin Composition>

The resin composition of the present embodiment may be produced by mixing each component with a known method. At this time, these components may be dissolved or dispersed with stirring. There is no particular restriction in the conditions such as a mixing order, a temperature, and a time; thus, the conditions may be determined as appropriate in accordance with raw materials and the like.

### [Prepreg]

The prepreg of the present embodiment contains the resin composition of the present embodiment or a semi-cured product of the said resin composition.

The prepreg of the present embodiment contains, for example, the resin composition of the present embodiment or a semi-cured product of the said resin composition, as well as a fiber substrate in a form of a sheet.

As for the fiber substrate in a form of a sheet of the present embodiment, for example, a known fiber substrate in a form of a sheet that is used in laminates for various electric insulating materials may be used.

Examples of the material for the fiber substrate in a form of a sheet include inorganic fibers such as an E glass, a D glass, an S glass, and a Q glass; organic fibers such as polyimide, polyester, and tetrafluoroethylene; and mixtures of these materials. These fiber substrates in a form of a sheet have the forms of a woven cloth, a unwoven cloth, a roving cloth, a chopped strand mat, a surfacing mat, and the like.

The prepreg of the present embodiment may be produced, for example, by the method in which the resin composition of the present embodiment is impregnated into or applied to the fiber substrate in a form of a sheet, which is then followed by heating and drying to make it to the state of B-stage.

The temperature and time for heating and drying may be set in the range of 50 to 200°C and 1 to 30 minutes, respectively, from the viewpoints of productivity and appropriately bringing the resin composition of the present embodiment to the B-stage, the temperature and the time.

The content of the resin composition in the prepreg of the present embodiment is not particularly limited, and is preferably in the range of 20 to 90 mass%, more preferably in the range of 25 to 80 mass%, and still more preferably in the range of 30 to 75 mass%, from the viewpoints of an enhanced moldability when it is made to a laminate.

### [Resin Film]

The resin film of the present embodiment contains the resin composition of the present embodiment or a semi-cured product of the said resin composition.

The resin film of the present embodiment may be produced, for example, by the method in which the resin composition of the present embodiment that contains an organic solvent is applied to a support, which then followed by heating and drying it.

Examples of the support include a plastic film, metal foil, and a releasing paper.

The temperature and time for heating and drying may be set in the range of 50 to 200°C and 1 to 30 minutes, respectively from the viewpoints of productivity and appropriately bringing the resin composition of the present embodiment to the B-stage.

The resin film of the present embodiment is used preferably to form an insulating layer when producing a printed wiring board.

### [Laminate]

The laminate of the present embodiment contains a cured product of the resin composition of the present embodiment and metal foil.

The laminate having metal foil is sometimes referred to as a metal-clad laminate.

There is no particular restriction in the metal of the metal foil. Examples thereof include copper, gold, silver, nickel, platinum, molybdenum, ruthenium, aluminum, tungsten, iron, titanium, chromium, and a metal alloy containing one or more metal elements described above.

The laminate of the present embodiment may be produced, for example, by the method in which the metal foil is disposed on one surface or both surfaces of the prepreg of the present embodiment, which is then followed by press-molding with heating.

Usually, by this press molding with heating, the prepreg in the state of the B-stage is cured to obtain the laminate of the present embodiment.

At the time when press-molding with heating, only one prepreg may be used, or a stack of 2 or more prepregs may be used.

Examples of the press-molding equipment with heating include a multi-stage pressing machine, a multi-stage vacuum pressing machine, a continuous molding machine, and an autoclave molding machine.

There is no particular restriction in the condition of press-molding with heating. For example, the temperature of 100 to 300°C, the time of 10 to 300 minutes, and the pressure of 1.5 to 5 MPa may be used.

### [Printed Wiring Board]

The printed wiring board of the present embodiment has a cured product of the resin composition of the present embodiment.

The printed wiring board of the present embodiment may be produced by forming a conductor circuit, for example, with a known method using one or more items selected from the group consisting of the cured product of the prepreg of the present embodiment, the cured product of the resin film of the present embodiment, and the laminate of the present embodiment. In addition, a multilayered wiring board may be produced by conducting a multilayer adhesion processing as needed. The conductor circuit may be formed, for example, by conducting as appropriate a drilling processing, a metal plating, a metal foil etching, or the like.

### [Semiconductor Package]

The semiconductor package of the present embodiment has the printed wiring board of the present embodiment and a semiconductor element.

The semiconductor package of the present embodiment may be produced, for example, with a known method in which a semiconductor chip, a memory, and the like are mounted onto the printed wiring board of the present embodiment.

### [Examples]

Hereinafter, the present embodiment will be specifically described by means of Examples. However, the present embodiment is not limited to Examples described below.

In each Example, the number-average molecular weight (Mn) and the weight-average molecular weight (Mw) were measured by the methods described below.

### (Measurement Methods of the Number-average Molecular Weight (Mn) and the Weight-average Molecular Weight (Mw))

The number-average molecular weight (Mn) and the weight-average molecular weight (Mw) were determined from the calibration curve using standard polystyrenes obtained by a gel permeation chromatography (GPC). The calibration curve was approximated in terms of a three-dimensional formula using standard polystyrenes: TSKstandard POLYSTYRENE (Type; A-2500, A-5000, F-1. F-2. F-4, F-10, F-20, and F-40) (manufactured by Tosoh Corp., trade name). The measurement condition of GPC was as follows.
Instrument: High speed GPC instrument HLC-8320GPC
Detector: UV absorbance detector UV-8320 (manufactured by Tosoh Corp.)
Columns: Guard column; TSK Guardcolumn SuperHZ-L + column: TSKgel SuperHZM-N + TSKgel SuperHZM-M + TSKgel SuperH-RC (all manufactured by Tosoh Corp., trade name)
Column size: 4.6 x 20 mm (guard column), 4.6 x 150 mm (column), 6.0 x 150 mm (reference column)
Eluent: Tetrahydrofuran
Sample concentration: 10 mg/5-mL
Injection volume: 25 µL
Flow rate: 1.00 mL/minute
Measurement temperature: 40°C

### (Measurement of Vinyl Group Modification Rate)

Using as the measurement objects the liquid including the conjugated diene polymer and the maleimide resin for modification before reaction, and the liquid including the modified conjugated diene polymer after the reaction, the GPC measurements were conducted with the above-mentioned condition. The vinyl group modification rate was obtained from the reduction rate of the peak areas derived from the maleimide resin for modification before and after the reaction, i.e., (peak area derived from maleimide resin for modification before reaction - peak area derived from maleimide resin for modification after reaction) x 100 / (peak area derived from maleimide resin for modification before reaction).

### (Production of Modified Conjugated Diene Polymer)

### Production Example 1

Into a 2-L glass-made flask equipped with a thermometer, a reflux cooling tube, and a stirrer, capable of being heated and cooled, were added 33.5 parts by mass of 1,2-polybutadiene homopolymer (the number-average molecular weight of 1,200 and the vinyl group content of 85% or more) as the conjugated diene polymer, 1.48 parts by mass of 4,4'-diphenylmethane bismaleimide as the maleimide resin for modification, 0.034 parts by mass of α,α'-bis(t-butylperoxy)diisopropylbenzene as the organic peroxide, and toluene as the organic solvent. The resulting mixture was reacted with stirring under a nitrogen atmosphere at 90 to 100°C for 5 hours to obtain a liquid containing the modified conjugated diene polymer (toluene diluent with solid concentration of 35 mass%). The vinyl group modification rate of the resulting conjugated diene polymer was 40% and the number-average molecular weight (Mn) thereof was 1,900.

### [Production of Resin Composition]

### Examples 1 to 5 and Comparative Examples 1 to 4

In accordance with the blending composition described in Table 1, the components described in Table 1 were mixed together with methyl ethyl ketone with stirring at room temperature to obtain the resin composition with the solid concentration of 55 mass%. Note that the blending unit of each component in Table 1 is parts by mass; in the case of a solution, this is expressed by parts by mass in terms of the solid content.

The varnish thereby obtained was applied to a 0.08-mm thick glass cloth, then this was dried by heating at 105°C for 4 minutes to obtain the prepreg with the resin composition content of about 75 mass%. Above and below the resulting prepreg, 18-µm thick low-profile copper foil were disposed such that the M-surface (mat surface) was in contact with the prepreg; then this was press-molded with heating at the temperature of 190°C and with the pressure pf 3.0 MPa for 80 minutes to obtain the double-sided copper-clad laminate (thickness of 0.60 mm).

### (Evaluation Methods)

Using the double-sided copper-clad laminate obtained in each Example, the measurements and evaluations were conducted in accordance with the methods described below. These results are summarized in Table 1.

### (Measurement Methods of Relative Dielectric Permittivity (Dk) and Dielectric Dissipation Factor (Df))

The double-sided copper clad laminate obtained in each Example was soaked in the 10 mass% solution of ammonium persulfate (manufactured by Mitsubishi Gas Chemical Company, Inc.), i.e., the copper etching solution, to remove the copper foil on both surfaces to obtain a testing specimen with the size of 2 mm x 50 mm. Then, in accordance with a cavity resonance perturbation method, the relative dielectric permittivity (Dk) and dielectric dissipation factor (Df) of the testing specimen were measured in the 10 GHz band and the environment temperature of 25°C.

### (Measurement Method of Thermal Expansion)

The copper foil on both surfaces of the double-sided copper clad laminate obtained in each Example was removed by etching to obtain an evaluation plate with the size of 5 mm square. Then, this was subjected to a thermal mechanical analysis with a compression method using a thermomechanical analyzer (TMA) (trade name: "Q400", manufactured by TA Instruments Japan, Inc.). After the evaluation plate was attached to the analyzer, this was continuously measured twice with the temperature raising rate of 10°C/minute. Here, the thermal expansion was measured in the thickness direction of the laminate, in which the average thermal expansion rate α1 in the temperature range of 30 to 120°C and the average thermal expansion rate α2 in the temperature range of 250 to 300°C in the second measurement were taken respectively.

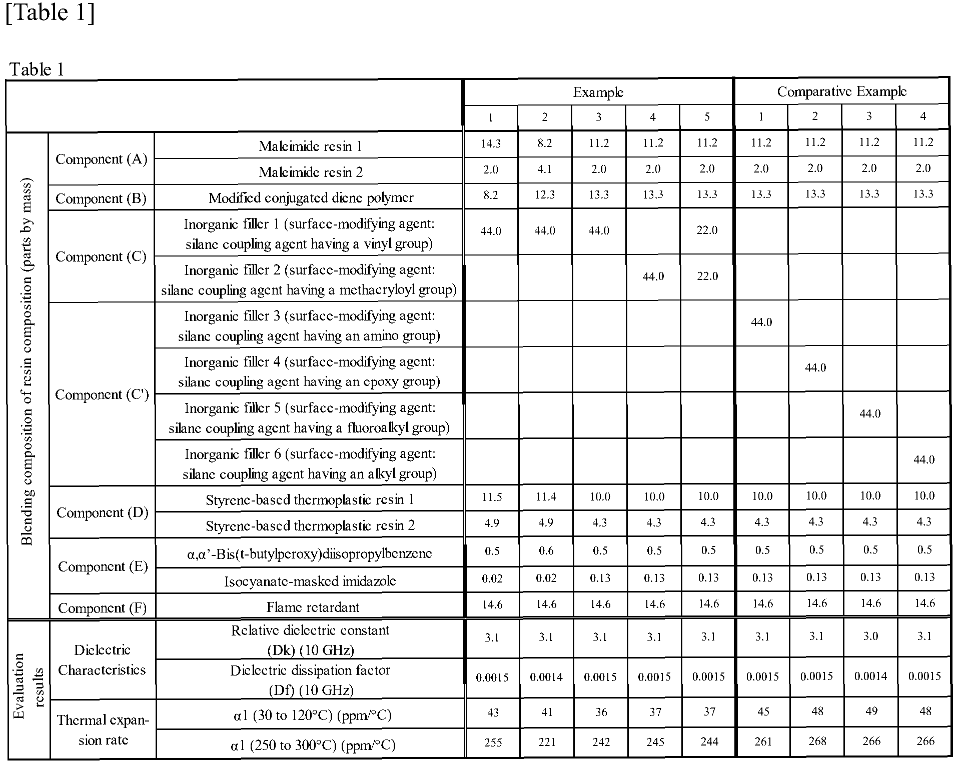

The details of the materials described in Table 1 are as follows.

### [Component (A)]

- Maleimide resin 1: Aromatic bismaleimide resin including an indane ring
- Maleimide resin 2: 4,4'-Diphenylmethane bismaleimide

### [Component (B)]

- Modified conjugated diene polymer: Modified conjugated diene polymer obtained in Production Example 1

### [Component (C)]

- Inorganic filler 1: Fused spherical silica whose surface was treated with the silane coupling agent having a vinyl group (average particle diameter of silica (D₅₀) is 0.5 µm.)
- Inorganic filler 2: Fused spherical silica whose surface was treated with the silane coupling agent having a methacryloyl group (average particle diameter of silica (D₅₀) is 0.5 µm.)

### [Component (C')]

- Inorganic filler 3: Fused spherical silica whose surface was treated with the silane coupling agent having an amino group (average particle diameter of silica (D₅₀) is 0.5 µm.)
- Inorganic filler 4: Fused spherical silica whose surface was treated with the silane coupling agent having an epoxy group (average particle diameter of silica (D₅₀) is 0.5 µm.)
- Inorganic filler 5: Fused spherical silica whose surface was treated with the silane coupling agent having a fluoroalkyl group (average particle diameter of silica (D₅₀) is 0.5 µm.)
- Inorganic filler 6: Fused spherical silica whose surface was treated with the silane coupling agent having an alkyl group (average particle diameter of silica (D₅₀) is 0.5 µm.)

### [Component (D)]

- Styrene-based thermoplastic resin 1: Styrene-ethylene-butylene-styrene block copolymer (SEBS), manufactured by Kraton Polymer Japan, Inc. "Kraton (registered trademark) MD6951", styrene content of 34 mass%, weight-average molecular weight (Mw) of 150,000
- Styrene-based thermoplastic resin 2: Styrene-ethylene-butylene-styrene block copolymer (SEBS), manufactured by Kraton Polymer Japan, Inc. "Kraton (registered trademark) MD1648", styrene content of 20 mass%, weight-average molecular weight (Mw) of 70,000

### [Component (E)]

- α,α'-Bis(t-butylperoxy)diisopropylbenzene
- Isocyanate-masked imidazole: Manufactured by DKS Co., Ltd., trade name "G8009L"

### [Component (F)]

- Flame retardant: Ethylenebis(pentabromophenyl), trade name "SAYTEX8010"

From Table 1, it can be seen that the resin compositions of the present embodiment in Examples 1 to 5 have superior dielectric characteristics and low thermal expansion. On the other hand, the resin compositions in Comparative Examples 1 to 4 have an inferior low thermal expansion.

## Claims

1. A resin composition comprising:
(A) a thermosetting resin,
(B) one or more selected from the group consisting of a conjugated diene polymer and its derivative, having 2 or more of a functional group including an ethylenically unsaturated bond, and
(C) an inorganic filler whose surface is treated with a silane coupling agent having a functional group including an ethylenically unsaturated bond.

2. The resin composition according to claim 1, wherein the component (A) is one or more selected from the group consisting of a maleimide resin having one or more of an N-substituted maleimide group and a derivative of the said maleimide resin.

3. The resin composition according to claim 1 or 2, wherein the component (B) is a resin having a vinyl group as the functional group including the ethylenically unsaturated bond.

4. The resin composition according to claim 1 or 2, wherein the silane coupling agent having the functional group including the ethylenically unsaturated bond is a silane coupling agent having a vinyl group or a (meth)acryloyl group as the functional group including the ethylenically unsaturated bond.

5. The resin composition according to claim 1 or 2, wherein the component (C) is a silica whose surface is treated with the silane coupling agent having the functional group including the ethylenically unsaturated bond.

6. The resin composition according to claim 1 or 2, wherein the resin composition further comprises (D) a styrene-based thermoplastic resin.

7. The resin composition according to claim 1 or 2, wherein the resin composition further comprises (E) a curing accelerator.

8. A prepreg comprising the resin composition according to claim 1 or 2 or a semi-cured product of the resin composition.

9. A laminate comprising a cured product of the resin composition according to claim 1 or 2 and metal foil.

10. A resin film comprising the resin composition according to claim 1 or 2 or a semi-cured product of the resin composition.

11. A printed wiring board comprising a cured product of the resin composition according to claim 1 or 2.

12. A semiconductor package comprising the printed wiring board according to claim 11 and a semiconductor element.
